# FASCICULE DE BREVET EUROPEEN

(11) **EP 0 685 943 B1**
(45) Date de publication et mention de la délivrance du brevet: **08.12.1999**
(21) Numéro de dépôt: 95401198.7
(22) Date de dépôt: 23.05.1995
(51) Int. Cl.: H03M 1/14, H03M 1/36

(54) **Convertisseur A/N de deux signaux analogiques utilisant un seul module convertisseur**
AD-Umwandler zweier Analogsignale mittels eines einzigen Wandlermoduls
AD converter of two analog signals using a single converting module

(30) Priorité: 24.05.1994 FR 9406264
(43) Date de publication de la demande: 06.12.1995
(73) Titulaire: THOMSON multimedia, 92648 Boulogne Cédex (FR)
(72) Inventeur: Dell'Ova, Francis, F-92050 Paris la Défense (FR); Paillardet, Frédéric, F-92050 Paris la Défense (FR); Bonhoure, Bruno, F-92050 Paris la Défense (FR)
(74) Mandataire: Ruellan-Lemonnier, Brigitte

(56) Documents cités:
- EP-A- 0 586 113
- GB-A- 2 190 258
- GB-A- 2 214 738

## Description

La présente invention concerne un convertisseur Analogique/Numérique (A/N) de type demi-flash ("half flash" en langue anglaise) permettant le multiplexage de deux signaux analogiques et ne nécessitant qu'un seul module convertisseur. Ce convertisseur est utilisé de préférence pour le traitement des signaux de télévision.

Pour la transmission et le traitement de signaux vidéo, on utilise trois types de signaux qui sont le signal de luminance Y et les signaux de chrominance (ou de différences de couleurs) U et V. La bande passante du signal Y étant supérieure à celle des signaux U et V, il est nécessaire, dans un convertisseur A/N, de convertir Y à une fréquence d'échantillonnage plus élevée (deux fois) que celle des deux autres composants U et V. Le problème se pose donc de la conversion A/N de plusieurs signaux en parallèle.

Pour résoudre ce problème, deux solutions techniques peuvent être mises en oeuvre. La première consiste à utiliser trois convertisseurs A/N pour digitaliser les signaux Y à la fréquence fs, U à fs/2, et V à fs/2. Cette solution logique a le mérite de la simplicité, mais comme principal inconvénient d'accroître la consommation et la surface. La seconde solution consiste à n'utiliser que deux convertisseurs A/N, cela est rendu possible grâce à l'utilisation d'un multiplexeur analogique pour multiplexer U et V et les digitaliser à la fréquence fs/2 par l'intermédiaire d'un premier convertisseur, le second convertisseur étant utilisé pour digitaliser Y à la fréquence fs. Cette seconde solution permet une consommation globale moindre, mais possède un inconvénient majeur lié à la difficulté de réalisation (vitesse, linéarité,...) du multiplexeur analogique.

La présente invention permet de bénéficier des avantages de ces deux solutions, notamment la simplicité et la faible consommation, sans en subir les inconvénients. Son principe repose sur l'utilisation d'un module convertisseur A/N de structure dite demi-flash incluant deux blocs "comparateurs fins" et un bloc "comparateur grossier".

En effet, il existe plusieurs types de conversion Analogique/Numérique (A/N), les uns privilégiant la rapidité de la conversion, les autres la consommation du circuit de conversion ou encore la taille de ce circuit. Un des principes couramment utilisé consiste à effectuer la conversion en deux temps. Dans un premier temps, on détermine dans quelle plage grossière se situe la tension à convertir à la fréquence fs. On obtient ainsi les bits de poids fort (MSB pour Most Significant Bits). Cette plage grossière servira dans un deuxième temps et avec un décalage de période de 1/fs, à établir une comparaison fine pour la détermination des bits de poids faible (LSB pour Least Significant Bits) à la fréquence fs/2. La fréquence de conversion globale est alors bien fs. La comparaison grossière étant plus rapide que la comparaison fine, on utilise deux blocs-comparateurs fins pour pouvoir faire deux cycles de comparaison grossière pendant le temps nécessaire à une comparaison fine.

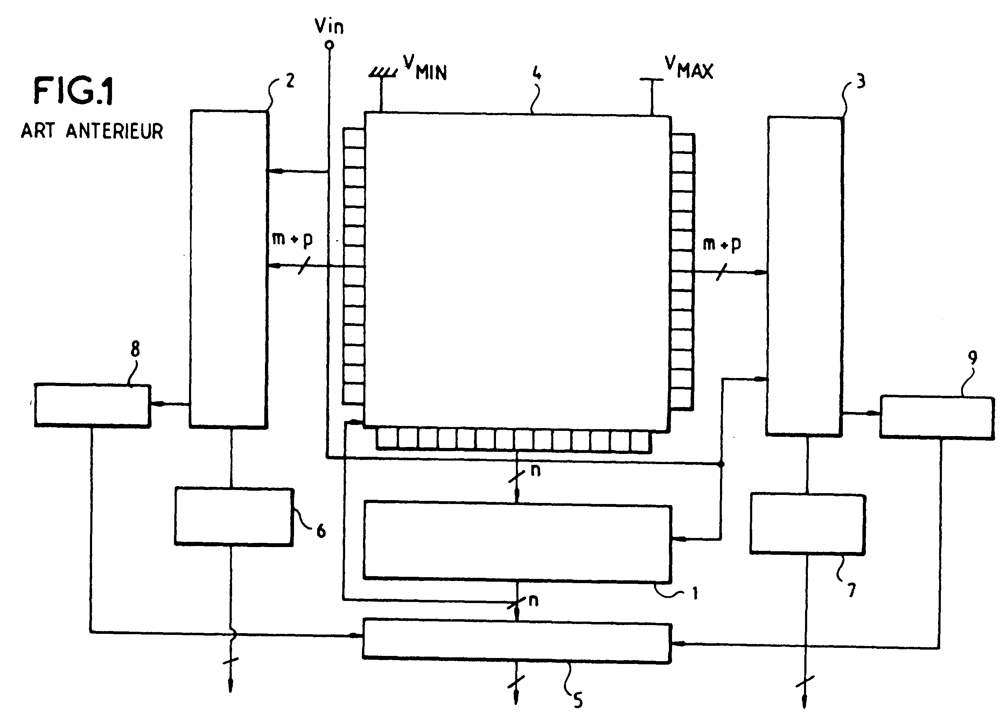

Ainsi, la figure 1 représente un convertisseur A/N de ce type utilisant un bloc-comparateur grossier 1 et deux blocs-comparateurs fins 2 et 3. La plage de tension comprise entre Vmin et Vmax est divisée en n + 1 intervalles égaux donnant n tensions de référence, chaque intervalle étant divisé lui-même en m + 1 intervalles égaux donnant m tensions de référence. Le bloc-comparateur grossier 1 reçoit en tant que tensions de référence les n tensions correspondant à Vmin + k x (Vmax - Vmin)/(n + 1) où k varie de 1 à n. La comparaison ainsi effectué, la plage grossière sélectionnée, divisée elle-même en n intervalles est appliquée au bloc-comparateur fin 2 ou 3 approprié. Les tensions de référence ainsi sélectionnées sont alors comparées à la tension à convertir Vin. Les blocs-comparateurs 1, 2 et 3 comportent respectivement n,m et m comparateurs en parallèle dont le rôle est de comparer chaque tension de référence Vref à la tension Vin. Le résultat consiste respectivement en des mots de n, m et m bits qui seront encodés par des encodeurs 5, 6 et 7 pour fournir les bits de poids fort MSB et bits de poids faible LSB.

Dans le but de corriger les écarts entre les références de tensions fournies au bloc-comparateur grossier 1 et aux blocs-comparateurs fins 2 et 3, p références supplémentaires sont fournies aux comparateurs fins 2 et 3. Ces p références correspondent aux intervalles fins adjacents à l'intervalle grossier déterminé par le bloc-comparateur grossier 1. Les blocs-comparateurs fins 2 et 3 comporteront alors chacun en parallèle m + p comparateurs. Cette information supplémentaire servira le cas échéant à corriger le ou les bits de plus faible poids LSB parmi ceux déterminés par le bloc-comparateur grossier. Les circuits de correction 8 et 9 effectuent de manière connue la correction du bit concerné issu de la comparaison grossière.

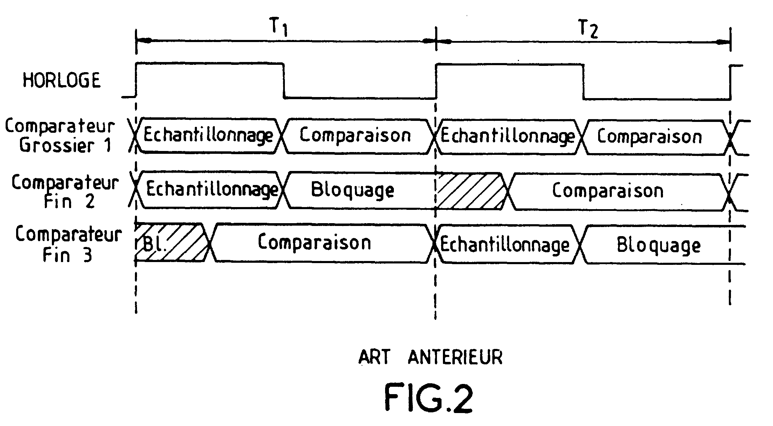

La figure 2 illustre le cycle des blocs-comparateurs 1, 2 et 3, un cycle complet de deux comparaisons grossières est représenté. Pendant la première période T1 du signal d'horloge, le bloc-comparateur grossier 1 échantillonne tout d'abord le signal Vin, puis effectue la comparaison avec les n tensions de référence. Pendant ce temps, le bloc-comparateur fin 2 aura lui aussi échantillonné et maintenu (bloqué) le signal Vin. Au début de la seconde période T2, le blocage est maintenu, en vue de permettre la stabilisation des tensions de référence fine (parties hachurées). C'est alors que la comparaison fine a lieu. Pendant cette seconde période, le bloc-comparateur grossier 1 échantillonne une seconde fois Vin, cette fois-ci pour la seconde comparaison fine par le bloc-comparateur 3.

L'exemple d'un tel convertisseur A/N demi-flash est décrit dans la demande de brevet Française 93 12026 de Thomson Consumer Electronics.

De plus, il est à noter que le document EP-A-586 113 décrit un convertisseur analogique-numérique ayant quatre entrées pour y connecter quatre canaux distincts et comportant des multiplexeurs pour multiplexer les signaux de ces quatre entrées sur un bloc-comparateur grossier et un bloc-comparateur fin.

En outre, le document GB-A-2 190 258 décrit un convertisseur analogique-numérique comprenant unbloc-comparateurgrossier et deux blocs-comparateurs fins pour recevoir alternativement le signal reçu par le convertisseur et dont la plage de conversion est déterminée par le bloc-comparateur grossier. Dans ce convertisseur, les convertisseurs fins n'ont à fonctionner qu'à la moitié du rythme du convertisseur grossier.

Un convertisseur A/N de deux signaux analogiques selon l'invention comporte un bloc-comparateur grossier et deux blocs-comparateurs fins, le bloc-comparateur grossier déterminant les bits de poids fort (MSB) et sélectionnant la plage de tension des blocs-comparateurs fins qui déterminent les bits de poids faibles (LSB). Une caractéristique importante de l'invention est que chacun des deux signaux est connecté à un bloc-comparateur fin, et que le bloc-comparateur grossier comporte des comparateurs comparant alternativement la première tension échantillonnée et la seconde tension échantillonnée à une même tension de référence.

Une autre caractéristique importante de la présente invention est que les comparateurs du bloc-comparateur grossier sont des comparateurs à autozéro comparant alternativement la première tension et la seconde tension à une même tension de référence. De même les comparateurs des blocs-comparateurs fins peuvent avantageusement être des comparateurs à autozéro.

La présente invention s'applique de préférence à un convertisseur réalisé en technologie MOS et utilisé pour le traitement des signaux de chrominance U et V de télévision.

Ainsi, la présente invention permet d'obtenir un convertisseur plus simple, consommant moins et moins encombrant que les convertisseurs connus.

La présente invention sera mieux comprise et les avantages supplémentaires apparaîtront à la lecture de la description qui va suivre, illustrée par les figures suivantes :
- la figure 1 déjà décrite représente un schéma fonctionnel d'un convertisseur A/N demi-flash connu ;
- la figure 2 déjà décrite représente l'évolution temporelle de cycles de fonctionnement des blocs-comparateurs fins et grossier de ce convertisseur A/N ;
- les figures 3a et 3b représentent des exemples de dispositifs comparateurs constituant les blocs-comparateurs fins et grossiers du convertisseur A/N selon l'invention, et
- la figure 4 représente le schéma fonctionnel d'un exemple de réalisation d'un convertisseur A/N selon l'invention.

Pour plus de clarté, les éléments des figures ayant les mêmes fonctions concervent les mêmes références d'une figure à l'autre.

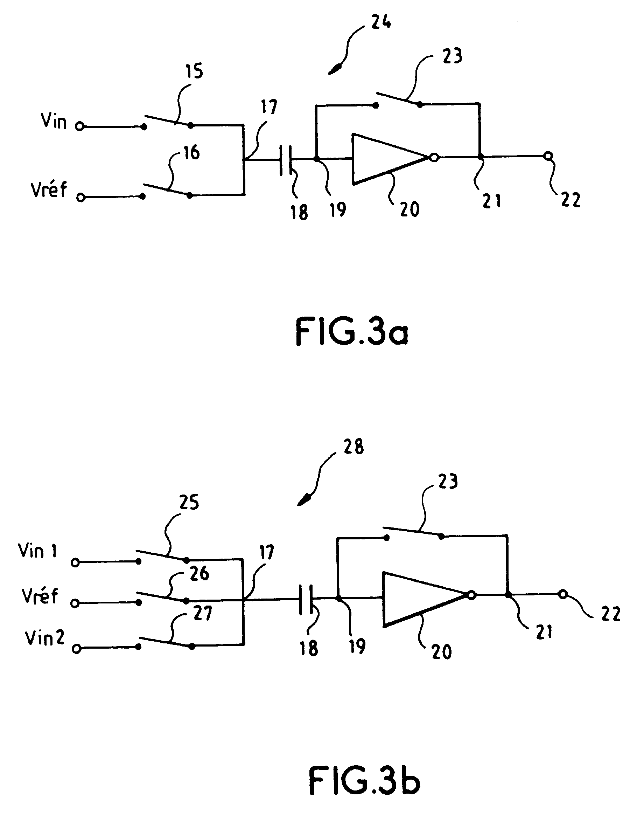

La figure 3a représente un comparateur dit à "auto-zéro" ("autozeroing comparator" en langue Anglaise). Ce comparateur est constitué de deux entrées Vin, tension à comparer, et Vref tension de comparaison. Ces deux entrées sont commandées par des interrupteurs 15 et 16, et connectées par le noeud 17 à la capacité de charge 18. Cette capacité 18 est connectée en série au noeud 19, à l'inverseur 20, au noeud 21 et à la sortie 22. Un interrupteur 23 en parallèle avec l'inverseur 20 relie les noeuds 19 et 21. La fonction auto-zéro est assurée par la fermeture de l'interrupteur 23 qui polarise l'inverseur 20 dans sa zone de seuil Vdd/2, Vdd étant la tension d'alimentation du circuit, le rendant ainsi très sensible aux différences de tensions aux bornes de la capacité 18. D'une manière analogue, la figure 3b représente un comparateur à auto-zéro étendu à la comparaison de deux tensions Vin1 et Vin2 par rapport à une tension de référence Vref. Il suffit de comparer alternativement Vin1 à Vref et Vin2 à Vref grâce aux interrupteurs 25, 26 et 27 pour réaliser une double comparaison par rapport à une même tension de comparaison.

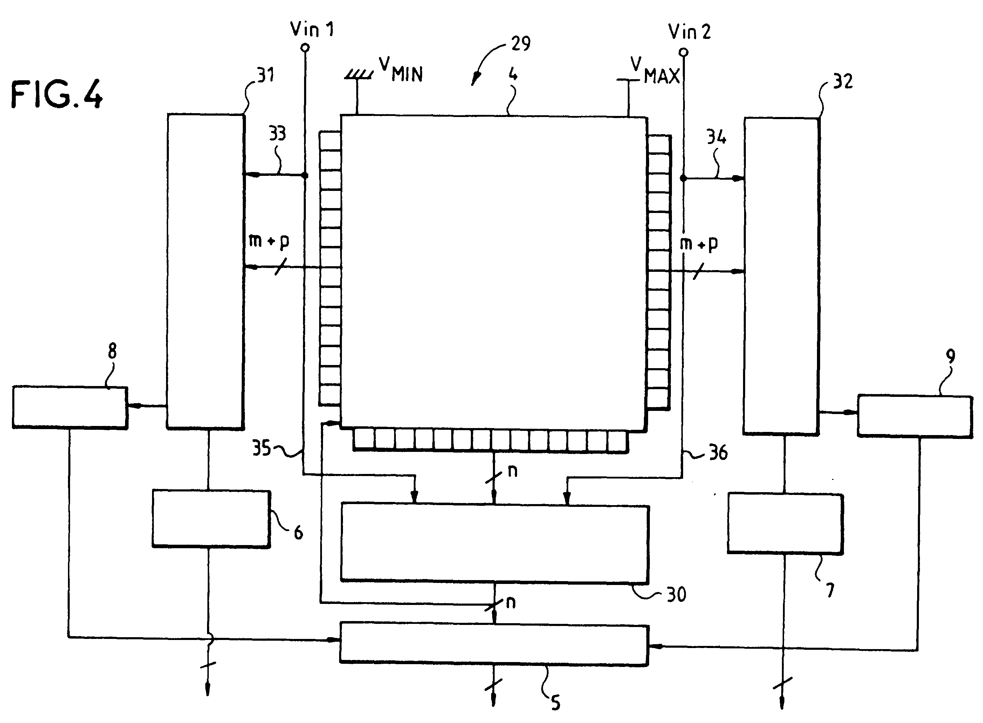

Comme cela est illustré sur la figure 4, un convertisseur A/N de deux signaux analogiques Vin1 et Vin2 comporte deux blocs-comparateurs fins 31 et 32. Selon une caractéristique importante de la présente invention, le premier bloc-comparateur fin 31 est associé au premier signal Vin1 par la connection 33, et le second bloc-comparateur fin 32 est associé au second signal Vin2 par la connection 34, ces blocs-comparateurs fins 31 et 32 étant réalisés par un ensemble de comparateurs à auto-zéro 24 du type de celui illustré par la figure 3a. D'autre part, selon une autre caractéristique importante de la présente invention, les deux signaux analogiques à convertir Vin1 et Vin2 sont parallèlement connectés au bloc-comparateur grossier 30, celui-ci étant réalisé par un ensemble de comparateurs à auto-zéro 28 du type de celui illustré par la figure 3b. Les autres éléments 4, 5, 6, 7, 8 et 9 de la figure 4 ont les mêmes fonctions que ceux de la figure 1.

Ainsi, le convertisseur 29 selon la présente invention de la figure 4 est équivalent à un double convertisseur A/N fonctionnant à la fréquence fs/2. La double comparaison grossière est assurée par le bloc-comparateur grossier 30 constitué de comparateurs 28 selon la figure 3b qui comparent alternativement Vin1 à Vref et Vin2 à Vref. La comparaison fine s'effectue grâce au bloc comparateur 31 pour le signal Vin1 et grâce au comparateur 32 pour le signal Vin2. La conversion s'effectue globalement toujours à fs mais Vin1 et Vin2 sont digitalisés à la sortie à la fréquence fs/2 respectivement.

On constate aisément que le convertisseur 29 selon la présente invention comporte de nombreux avantages dont celui de permettre la conversion A/N de deux signaux d'entrée différents à fs/2 sans surcoût de consommation par rapport à une seule conversion A/N à la fréquence fs. Il permet d'autre part le gain de la consommation et de l'encombrement d'un convertisseur A/N dans l'exemple évoqué plus haut du triple signal vidéo Y, U et V. Par rapport à une solution classique du type de celle proposée plus haut, un multiplexeur analogique périphérique peut être éliminé. De plus, du fait de la structure d'un convertisseur A/N selon l'ivention comme par exemple celui de la figure 4, l'isolation des deux signaux Vin1 et Vin2 et très bien maîtrisée puisque la comparaison fine reste associée de façon indépendante à chaque signal d'entrée.

La présente invention peut s'appliquer à tous les types de conversion A/N de deux signaux analogiques Vin1 et Vin2, et en particulier au traitement des signaux de chrominance U et V d'un signal de télévision.

## Revendications

1. Convertisseur Analogique/Numérique (29) de deux signaux analogiques (Vin1,Vin2) comportant un bloc-comparateur grossier (30) et deux blocs-comparateurs fins (31,32), le bloc-comparateur grossier (30) déterminant les bits de poids fort (MSB) et sélectionnant la plage de tension des blocs-comparateurs fins (31,32) qui déterminent les bits de poids faibles (LSB), caractérisé en ce qu'il comporte deux entrées pour recevoir chacun des deux signaux analogiques (Vin1,Vin2), chacune étant connectée à un bloc-comparateur fin (31,32), et en ce que le bloc-comparateur grossier (30) comporte des comparateurs (28) comparant alternativement la première tension échantillonnée (Vin1) et la seconde tension échantillonée (Vin2) à une même tension de référence (Vref).

2. Convertisseur A/N (29) selon la revendication 1 caractérisé en ce que les comparateurs (28) du bloc-comparateur grossier (30) sont des comparateurs à autozéro (24) comparant alternativement la première tension (Vin1) et la seconde tension (Vin2) à une même tension de référence (Vref).

3. Convertisseur A/N (29) selon l'une quelconque des revendications précédentes caractérisé en ce que les deux blocs-comparateurs fins (31,32) sont constitués de comparateurs à autozéro (24).

4. Convertisseur A/N (29) selon l'une quelconque des revendications précédentes, caractérisé en ce que les comparateurs (28) du bloc-comparateur grossier (30) sont constitués d'une première entrée pour le premier signal à comparer (Vin1), d'une seconde entrée pour le signal de référence (Vref) et d'une troisième entrée pour le second signal à comparer (Vin2), chacune de ces entrées étant commandé par un interrupteur (25,26,27) et connectée au même noeud (17), lui même connecté en série à une capacité (18) et à un inverseur (20) dont les bornes (19,21) sont reliée par un interrupteur (23).

5. Convertisseur A/N (29) selon l'une quelconque des revendications précédentes caractérisé en ce qu'il est réalisé en technologie MOS.

6. Convertisseur A/N (29) selon l'une quelconque des revendications précédentes caractérisé en ce qu'il convertit en deux signaux numériques les deux signaux analogiques de chrominance (U,V) d'un signal de télévision.

7. Convertisseur A/N de signaux analogiques de télévision (Y,U,V) en signaux numériques caractérisé en ce qu'il comporte un premier module convertisseur A/N (29) selon l'une quelconque des revendications précédentes pour le traitement des signaux de chrominance (U,V) et un second module convertisseur A/N pour le signal de luminance (Y).

8. Téléviseur numérique caractérisé en ce qu'il comporte au moins un convertisseur A/N (29) selon l'une quelconque des revendications précédentes.

## Patentansprüche

1. Analog/Digital-Wandler (29) für zwei analoge Signale (Vin1, Vin2), enthaltend: einen Grob-Komparatorblock (30) und zwei Fein-Komparatorblöcke (31, 32), wobei der Grob-Komparatorblock (30) die höchstwertigen Bit (MSB) ermittelt und den Spannungsbereich der Fein-Komparatorblöcke (31, 32) auswählt, die die geringstwertigen Bit (LSB) ermitteln, dadurch gekennzeichnet, daß der Wandler zwei Eingänge zum Empfangen jedes der beiden analogen Signale (Vin1, Vin2) enthält, die beide an einen Fein-Komparatorblock (31, 32) angelegt sind, und daß der Grob-Komparatorblock (30) Komparatoren (28) enthält, die abwechselnd die erste abgetastete Spannung (Vin1) und die zweite abgetastete Spannung (Vin2) mit derselben Referenzspannung (Vref) vergleichen.

2. A/D-Wandler (29) nach Anspruch 1, dadurch gekennzeichnet, daß die Komparatoren (28) des Grob-Komparatorblocks (30) Komparatoren mit selbsttätiger Nulleinstellung (autozero) (24) sind, die abwechselnd die erste Spannung (Vin1) und die zweite Spannung (Vin2) mit derselben Referenzspannung (Vref) vergleichen.

3. A/D-Wandler (29) nach einem der vorangehenden Ansprüche, dadurch gekennzeichnet, daß die beiden Fein-Komparatorblöcke (31, 32 durch Komparatoren mit selbsttätiger Nulleinstellung (autozero) (24) gebildet sind.

4. A/D-Wandler (29) nach einem der vorangehenden Ansprüche, dadurch gekennzeichnet, daß die Komparatoren (28) des Grob-Komparatorblocks (30) einen ersten Eingang für das erste zu vergleichende Signal (Vin1), einen zweiten Eingang für das Referenzsiganl (Vref) und einen dritten Eingang für das zweite zu vergleichende Signal (Vin2) bilden, daß jeder dieser Eingänge durch einen Schalter (25, 26, 27) gesteuert und mit demselben Schaltungspunkt (17) verbunden ist, der in Reihe mit einer Kapazität (18) und einem Inverter (20) geschaltet ist, dessen Anschlußklemmen (19, 21) über einen Schalter (23) miteinander verbunden sind.

5. A/D-Wandler (29) nach einem der vorangehenden Ansprüche, dadurch gekennzeichnet, daß der Wandler in MOS-Technologie ausgeführt ist.

6. A/D-Wandler (29) nach einem der vorangehenden Ansprüche, dadurch gekennzeichnet, daß der Wandler die beiden analogen Chrominanzsignale (U, V) eines Fernsehsignals in zwei digitale Signale umsetzt.

7. A/D-Wandler zum Umsetzen von analogen Fernsehsignalen (Y, U, V) in digitale Signale, dadurch gekennzeichnet, daß der Wandler ein erstes A/D-Wandlermodul (29) nach einem der vorangehenden Ansprüche für die Verarbeitung von Chrominanzsignalen (U, V) und ein zweites A/D-Wandlermodul für das Luminanzsignal (Y) enthält.

8. Digitales Fernsehgerät, dadurch gekennzeichnet, daß es wenigstens einen A/D-Wandler (29) nach einem der vorangehenden Ansprüche enthält.

## Claims

1. Analogue/Digital converter (29) of two analogue signals (Vin1, Vin2) comprising a coarse comparator block (30) and two fine comparator blocks (31, 32), the coarse comparator block (30) determining the most significant bits (MSB) and selecting the voltage span of the fine comparator blocks (31, 32) which determine the least significant bits (LSB), characterized in that it comprises two inputs for receiving each of the two analogue signals (Vin1, Vin2), each being connected to a fine comparator block (31, 32), and in that the coarse comparator block (30) comprises comparators (28) alternately comparing the first sampled voltage (Vinl) and the second sampled voltage (Vin2) with the same reference voltage (Vref).

2. A/D converter (29) according to Claim 1, characterized in that the comparators (28) of the coarse comparator block (30) are auto-zeroing comparators (24) alternately comparing the first voltage (Vin1) and the second voltage (Vin2) with the same reference voltage (Vref).

3. A/D converter (29) according to either one of the preceding claims, characterized in that the two fine comparator blocks (31, 32) consist of auto-zeroing comparators (24).

4. A/D converter (29) according to any one of the preceding claims, characterized in that the comparators (28) of the coarse comparator block (30) consist of a first input for the first signal to be compared (Vin1), a second input for the reference signal (Vref) and a third input for the second signal to be compared (Vin2), each of these inputs being controlled by a switch (25, 26, 27) and connected to the same node (17), itself connected in series to a capacitor (18) and to an inverter (20) whose terminals (19, 21) are linked by a switch (23).

5. A/D converter (29) according to any one of the preceding claims, characterized in that it is constructed in MOS technology.

6. A/D converter (29) according to any one of the preceding claims, characterized in that it converts the two analogue chrominance signals (U,V) of a television signal into two digital signals.

7. A/D converter of analogue television signals (Y,U,V) into digital signals, characterized in that it comprises a first A/D converter module (29) according to any one of the preceding claims for processing the chrominance signals (U,V) and a second A/D converter module for the luminance signal (Y).

8. Digital television set characterized in that it comprises at least one A/D converter (29) according to any one of the preceding claims.
